(19) Europäisches Patentamt
European Patent Office
Office européen des brevets

(11) **EP 2 678 747 B1**

(12) **FASCICULE DE BREVET EUROPEEN**

(45) Date de publication et mention de la délivrance du brevet:
**06.06.2018 Bulletin 2018/23**

(21) Numéro de dépôt: **12709921.6**

(22) Date de dépôt: **16.02.2012**

(51) Int Cl.:
***G05B 23/02*** *(2006.01)*

(86) Numéro de dépôt international:
**PCT/FR2012/050338**

(87) Numéro de publication internationale:
**WO 2012/114021 (30.08.2012 Gazette 2012/35)**

(54) **PRÉVISION D'OPÉRATIONS DE MAINTENANCE SUR UN MOTEUR D'AÉRONEF**

PROGNOSE VON WARTUNGSARBEITEN FÜR EIN FLUGZEUGTRIEBWERK

FORECASTING MAINTENANCE OPERATIONS FOR AN AIRCRAFT ENGINE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.02.2011 FR 1151543**

(43) Date de publication de la demande:
**01.01.2014 Bulletin 2014/01**

(73) Titulaire: **SNECMA**
**75015 Paris (FR)**

(72) Inventeurs:
• **DELAYE, Guillaume**
  **77550 Moissy-Cramayel (FR)**
• **AUTIER, Jean-Philippe**
  **77550 Moissy-Cramayel (FR)**
• **GENDRONNEAU, Eric**
  **77550 Moissy-Cramayel (FR)**

(74) Mandataire: **Ilgart, Jean-Christophe et al**
**BREVALEX**
**95, rue d'Amsterdam**
**75378 Paris Cedex 8 (FR)**

(56) Documents cités:
**US-A1- 2004 204 805    US-A1- 2007 088 584**
**US-A1- 2010 070 237**

**Description**

## DOMAINE DE L'INVENTION

La présente invention se rapporte au domaine de la maintenance d'un moteur d'aéronef. En particulier, l'invention concerne un procédé et un système pour anticiper ou prévoir les opérations de maintenance sur un moteur d'aéronef.

De manière générale, on intervient sur le moteur directement en fonction de la cause de défaillance, sans se préoccuper des autres paramètres. Par exemple, si une fuite d'huile a été détectée, on agit sur le circuit d'huile et ainsi de suite.

Cependant, une opération de maintenance sur un moteur d'aéronef peut nécessiter une longue période d'immobilisation et des coûts importants de pièces et de mains d'oeuvre.

Alors, afin d'optimiser et de planifier les opérations de maintenance, on exploite le retour d'expérience accumulée par les réparateurs dans les ateliers sur les causes de défaillances pour tracer des courbes de défaillances statistiques selon des lois de Weibull. L'outil utilisé actuellement consiste à attribuer de manière systématique un niveau d'intervention (workscope, en anglais) moyen basé sur les courbes de défaillances statistiques de Weibull.

Or, le fait d'attribuer le même niveau d'intervention moyen à toutes les causes de défaillance ne permet pas de tenir compte des spécificités ou de l'historique du moteur.

Ceci engendre un manque de précision dans les prévisions des opérations de maintenance et peut induire une maintenance incomplète du moteur qui peut alors retomber en panne peu après sa sortie de l'atelier. Le document d'art antérieur "US 2007/088584 A1" décrit un procédé de prévision d'opérations de maintenance sur un moteur d'aéronef courant ainsi qu'un un système de prévision d'opérations de maintenance sur un moteur d'aéronef courant. L'objet de la présente invention est par conséquent de prévoir les opérations de maintenance sur un moteur d'aéronef avec une grande précision sans présenter les inconvénients précités.

## OBJET ET RÉSUMÉ DE L'INVENTION

La présente invention concerne un procédé de prévision d'opérations de maintenance sur un moteur d'aéronef courant, comportant les étapes suivantes :

- confronter un ensemble de modèles de défaillances adaptés audit moteur courant pour sélectionner un modèle de défaillance pertinent ayant un âge de défaillance définissant l'âge dudit moteur au moment de la défaillance ;
- associer audit modèle de défaillance pertinent des règles de décision de niveau d'intervention sur ledit moteur courant en fonction d'un ensemble de paramètres relatifs audit moteur courant ; et
- déterminer en fonction desdites règles de décision le niveau d'intervention requis de maintenance à accomplir sur ledit moteur courant.

Ainsi, le procédé tient compte des causes de défaillance et de toute l'expression de leurs effets permettant de discriminer un moteur par rapport à un autre et d'y associer de façon beaucoup plus fine un niveau d'intervention technique spécifique à chaque moteur. Ceci permet de pronostiquer et de planifier les opérations de maintenance avec une très grande précision.

Avantageusement, ledit ensemble de paramètres comporte les paramètres suivants : âge de défaillance, durée de fonctionnement dudit moteur courant depuis un dernier passage en atelier, rang de passage en atelier, potentiel de durée de vie restant pour chacune d'une pluralité de pièces à durée limitée LLP dudit moteur courant, et contraintes de reconstruction dudit moteur.

Selon un mode de réalisation de la présente invention, lesdites règles de décision comportent un premier module de règles définissant une pluralité de niveaux d'intervention par rapport à des durées de fonctionnement dudit moteur, et en ce qu'un niveau pertinent est sélectionné parmi ladite pluralité de niveaux d'intervention en fonction dudit âge de défaillance associé audit modèle de défaillance pertinent.

Ledit premier module de règles est sélectionné parmi un ensemble de premiers modules de règles définis auparavant lors d'une phase d'initialisation, chacun desdits premiers modules de règles étant associé à un modèle de défaillance déterminé et à un rang déterminé de passage en atelier.

Avantageusement, lesdites règles de décision comportent un second module de règles définissant des relations entre les niveaux d'intervention dudit premier module de règles et des opérations de maintenance, et ledit niveau d'intervention requis de maintenance est déterminé en fonction dudit niveau pertinent, des contraintes de reconstruction dudit moteur, et des potentiels de durée de vie restant pour chacune d'une pluralité de pièces à durée limitée LLP dudit moteur courant.

Avantageusement, ledit ensemble de paramètres est réadapté après l'accomplissement de l'opération de maintenance sur ledit moteur courant.

Lesdits modèles de défaillances sont issus d'analyse du retour d'expérience sur une flotte de moteurs comportant les données suivantes : nombre de moteurs, environnement d'opération de chaque moteur, modèle de chaque moteur, condition opérationnelle de chaque moteur, lieu d'entretien de chaque moteur, durée entre l'entrée et la sortie de chaque moteur de l'atelier.

L'invention vise aussi un programme d'ordinateur comportant des instructions de code pour la mise en oeuvre du procédé de prévision selon les caractéristiques ci-dessus lorsqu'il est exécuté par des moyens de traitement.

L'invention vise également un système de prévision d'opérations de maintenance sur un moteur d'aéronef courant, comportant :

- des moyens de traitement pour confronter un ensemble de modèles de défaillances adaptés audit moteur courant pour sélectionner un modèle de défaillance pertinent ayant un âge de défaillance définissant l'âge dudit moteur au moment de la défaillance ;
- des moyens de traitement pour associer audit modèle de défaillance pertinent des règles de décision de niveau d'intervention sur ledit moteur courant en fonction d'un ensemble de paramètres relatifs audit moteur courant ; et
- des moyens de traitement pour déterminer en fonction desdites règles de décision le niveau d'intervention requis de maintenance à accomplir sur ledit moteur courant.

**BRÈVE DESCRIPTION DES DESSINS**

D'autres particularités et avantages du dispositif et du procédé selon l'invention ressortiront mieux à la lecture de la description faite ci-après, à titre indicatif mais non limitatif, en référence aux dessins annexés sur lesquels :

- la Fig. 1 illustre de manière schématique des moyens matériels mis en oeuvre dans le système ou procédé qui peuvent être employés pour la prévision d'opérations de maintenance sur un moteur d'aéronef selon l'invention ;
- la Fig. 2 illustre le procédé de prévision d'opérations de maintenance sur un moteur d'aéronef donné selon l'invention ;
- la Fig. 3 illustre un mode de réalisation particulier du procédé de prévision d'opérations de maintenance de la Fig. 2 ; et
- la Fig. 4 illustre un exemple d'un premier module de règles définissant une pluralité de niveaux d'intervention selon l'invention.

**DESCRIPTION DÉTAILLÉE DE MODES DE RÉALISATION**

Le principe de l'invention consiste à exploiter au mieux l'historique de pannes d'une flotte de moteurs pour prévoir les opérations de maintenance à venir avec une grande précision. Ainsi, en tenant compte des paramètres les plus influents dans les causes de défaillance, il est possible de déduire de manière non supervisée et très fine le niveau d'intervention sur un moteur.

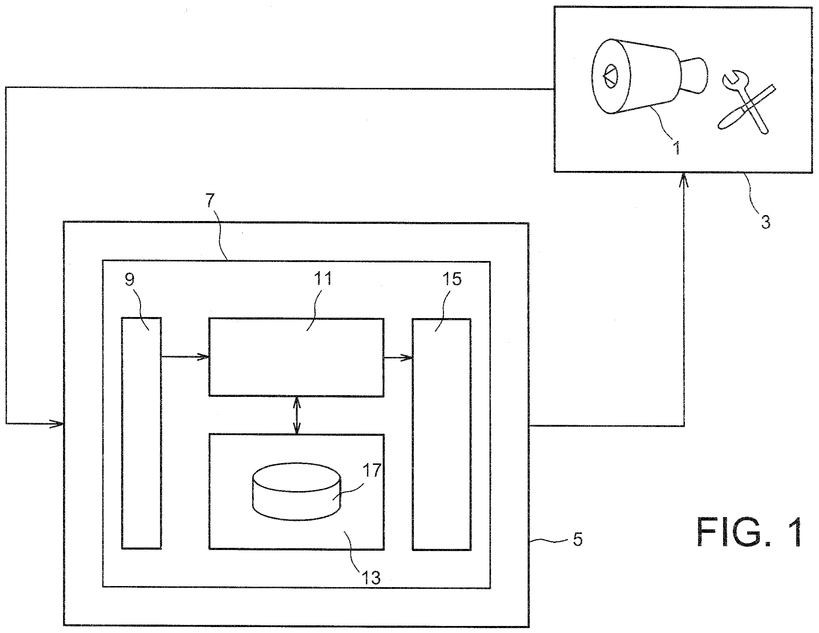

La figure 1 illustre un exemple de moyens matériels mis en oeuvre dans le système ou procédé de prévision d'opérations de maintenance sur un moteur d'aéronef selon l'invention.

Lors des passages des moteurs 1 en ateliers 3, les réparateurs accumulent une expérience sur les causes de défaillances et les niveaux d'intervention. Ce retour d'expérience est exploité par le système de prévision 5 pour construire des modèles de défaillance permettant de prévoir les opérations de maintenance à réaliser sur les moteurs d'aéronef.

Plus particulièrement, le système de prévision 5 comporte un système informatique 7 comprenant de manière habituelle des moyens d'entrée 9, des moyens de traitement 11, des moyens de stockage 13, et des moyens de sortie 15. On notera que les moyens de stockage 13 peuvent comporter un programme d'ordinateur comprenant des instructions de code adaptées à la mise en oeuvre du procédé de prévision selon l'invention. Ce programme d'ordinateur peut être exécuté par les moyens de traitement 11 en relation avec les moyens de stockage 13 et les moyens d'entrée 9 et de sortie 15.

Les différentes données issues du retour d'expérience depuis les différents ateliers 3 sont stockées dans les moyens de stockage 13 pour constituer une base de données 17 sur toute une flotte de moteurs. D'autres données concernant les moteurs sont aussi enregistrées dans la base de données 17 pour enrichir les informations relatives aux moteurs.

La base de données 17 comporte ainsi une pluralité de mesures et données recueillies au cours du temps sur les moteurs 1. Ces données comportent les différentes causes de défaillances et le niveau d'intervention sur chaque moteur, le nombre de moteurs traités ou à traiter, l'environnement d'opération de chaque moteur, le modèle et identifiant de chaque moteur, la condition opérationnelle de chaque moteur, le lieu d'entretien de chaque moteur, la durée entre l'entrée et la sortie de chaque moteur de l'atelier, etc.

Le procédé selon l'invention permet de modéliser le comportement d'une flotte complète de moteurs produisant une prévision de nombre de déposes moteurs et les niveaux d'interventions sur les différents moteurs en fonction des différentes données d'entrées concernant la flotte enregistrées dans la base de données 17. Ce procédé gère également l'antériorité technique des moteurs en prenant en compte leurs vieillissements dans la détermination des plans de dépose, niveaux d'interventions et dates de passage en atelier 3 des différents moteurs 1.

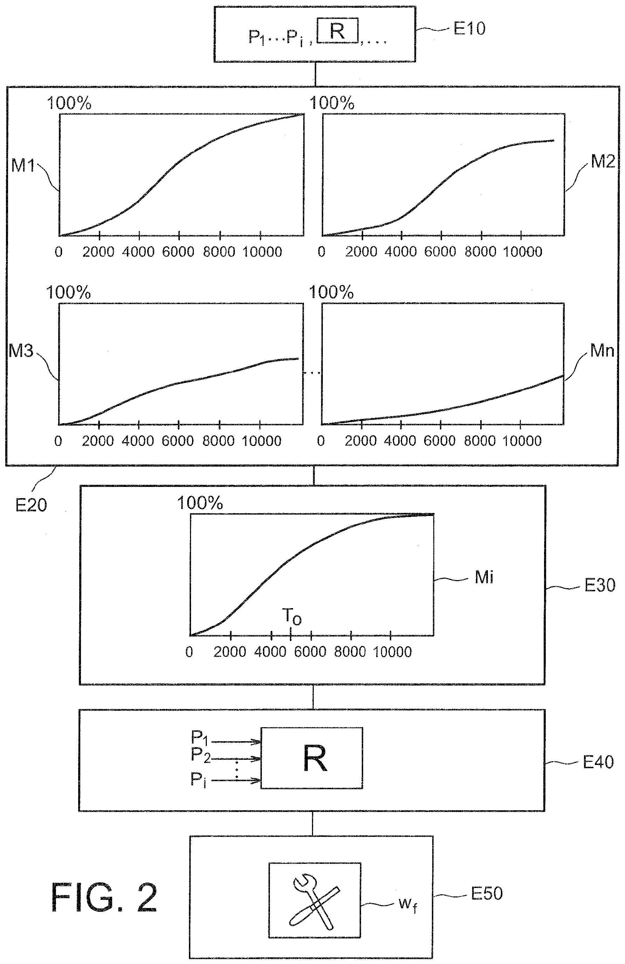

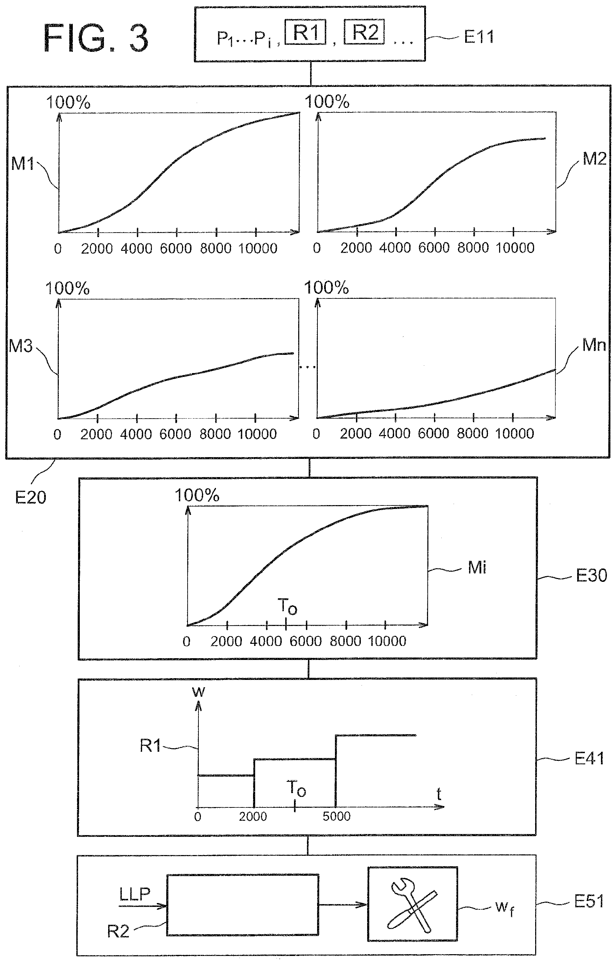

Plus particulièrement, les moyens de traitement 11 sont configurés pour exploiter les données enregistrées dans la base de données 17 afin de déterminer des modèles de défaillances statistiques modélisant les causes de défaillance en fonction du temps. Plus précisément, les moyens de traitement 11 associent un ensemble de modèles de défaillances adaptés à chaque modèle de moteur et à son utilisation. Chaque modèle de défaillance peut être exprimé sous la forme d'une courbe de probabilité cumulé de défaillances en fonction du temps (voir par exemple Figs. 2 et 3).

Avantageusement, les modèles de défaillances peuvent être basés sur une loi de Weibull qui est très adaptée pour modéliser la durée de vie ou la défaillance d'un composant du moteur 1. La densité de probabilité $f(t; \beta, \eta, \gamma)$ d'une distribution de Weibull peut être exprimée sous la forme suivante :

$$f(t; \beta, \eta, \gamma) = \frac{\beta}{\eta} \left( \frac{t - \gamma}{\eta} \right)^{k-1} e^{-\left( \frac{t - \gamma}{\eta} \right)^{\beta}}$$

Cette loi est extrêmement flexible grâce à la prise en compte de trois paramètres : paramètre de forme $\beta$, paramètre d'échelle $\eta$, et paramètre de localisation $\gamma$.

La fonction de répartition ou la probabilité de défaillance pour la loi de Weibull est alors définie par :

$$F(t; \beta, \eta, \gamma) = 1 - e^{-\left( \frac{t - \gamma}{\eta} \right)^{\beta}}$$

Grâce à la souplesse de cette loi, la grande majorité des relevés de défaillance peuvent être décrits de manière adéquate par une distribution de Weibull. Cela s'explique notamment par le fait qu'elle est capable de reproduire le comportement d'autres lois de probabilités. Par exemple, si $\beta$=1, la loi de Weibull est équivalente à une distribution exponentielle ; si $\beta$=2, elle est équivalente à une distribution de Rayleigh ; si 3<$\beta$<4, elle est équivalente à une distribution normale ; si $\beta \to \infty$, elle est équivalente à une distribution de type Dirac. Dans certains autres cas, elle reproduit également la loi binomiale et la loi de Poisson.

Bien entendu, pour un composant du moteur 1 présentant plusieurs modes de défaillances au cours du temps, la loi de Weibull peut être définie selon différents paramètres en fonction de l'âge du composant. A titre d'exemple, au départ le taux de défaillance d'un composant peut être décroissant ($\beta$<1) ce qui relève d'une « mortalité infantile ». Autrement dit, les composants fragiles tombent en panne tout au début de manière rapide engendrant une diminution du taux de défaillance après la suppression des composants défectueux. Ensuite, le taux de défaillance reste stationnaire ($\beta$=1) tout au long de la vie utile du composant. Finalement, le taux de défaillance commence à croître ($\beta$>1) lors d'une phase naturelle d'usure. Les trois modes de défaillance forment alors une courbe continue en forme de baignoire.

On notera que pour des composants qui présentent certains phénomènes non linéaires tels que la fissuration, on peut utiliser d'autres lois statistiques. Dans ce genre de phénomènes, on peut utiliser des distributions plus adaptées de type log-normale.

La Fig. 2 illustre le procédé de prévision d'opérations de maintenance sur un moteur d'aéronef donné selon l'invention.

L'étape E10 concerne l'initialisation de données, paramètres, et variables d'entrées. Ces entrées comportent le modèle du moteur, son environnement d'opération, ses conditions opérationnelles, des modèles de défaillances adaptés à ce moteur, etc.

Les entrées comportent également des paramètres P1, P2,..., Pi les plus influents dans le lien entre une cause probable de défaillance et un niveau d'intervention ainsi qu'un ensemble de règles R de décision de niveau d'intervention sur le moteur 1.

L'ensemble de paramètres influents P1, P2,..., Pi comporte des paramètres concernant l'âge du moteur ainsi que les contraintes de reconstruction (min built, en anglais) du moteur.

Par ailleurs, les règles R de décision peuvent être des règles logiques construites en fonction de différents modèles de défaillance et de l'ensemble de paramètres.

A l'étape E20, les moyens de traitement 11 disposent, en provenance des moyens de stockage 13, de l'ensemble de modèles de défaillances M1, M2, M3,..., Mn adaptés au moteur 1 sous surveillance. Chacun des modèles de défaillances est représenté par une loi de probabilité cumulée de défaillance entre 0 et 100% en fonction du temps exprimé par exemple en heure ou en nombre de cycles du moteur sous l'aile. On notera qu'un cycle correspond à l'ensemble de phases de vol (décollage, vol, et atterrissage). Ces modèles de défaillances M1, M2, M3,..., Mn peuvent être affichés sur un écran compris dans les moyens de sortie 15.

A l'étape E30, les moyens de traitement 11 sont configurés pour confronter l'ensemble de modèles de défaillances M1, M2, M3,..., Mn afin de sélectionner un modèle de défaillance pertinent Mi avec un âge de défaillance $T_0$ définissant l'âge qu'aura le moteur 1 au moment de la défaillance.

Avantageusement, la sélection du modèle pertinent est réalisée selon une simulation par tirages de Monte-Carlo sur l'ensemble de modèles de défaillances M1, M2, M3,..., Mn. La simulation de Monte-Carlo permet de déterminer des sorties déterministes à partir des entrées stochastiques correspondant aux distributions de probabilité des modèles de défaillances M1, M2, M3,..., Mn de type loi de Weibull. En effet, grâce à la loi des grands nombres, la simulation de Monte-Carlo permet d'associer à une probabilité d'occurrence d'un événement, un nombre déterministe d'occurrences de cet événement.

Dans ce cas, la distribution de probabilité de bon fonctionnement H(t) d'un composant du moteur 1 peut s'exprimer en fonction de la probabilité de défaillance (ou fonction de répartition) F(t) après un temps t par l'expression suivante :

$$H(t) = 1 - F(t) = e^{-\left( \frac{t - \gamma}{\eta} \right)^{\beta}} \Leftrightarrow 1 - P = e^{-\left( \frac{t}{\eta} \right)^{\beta}}$$

où P est un nombre aléatoire compris entre 0 et 1 tiré par la simulation de Monte-Carlo correspondant à la probabilité de défaillance après un temps t.

Ainsi, le temps t qui correspond à l'âge du moteur au moment de la défaillance est donné par la formule suivante :

$$t = -\eta \times \ln(1-P)^{1/\beta}$$

Les moyens de traitement 11 effectuent ce calcul pour chacun de l'ensemble des modèles de défaillance M1, M2, M3,..., Mn engendrant ainsi un ensemble d'âges de défaillance $\{t_1, t_2, ..., t_n\}$.

Les moyens de traitement 11 sont configurés pour sélectionner un âge de défaillance pertinent parmi cet ensemble d'âges de défaillance ainsi que le modèle de défaillance correspondant à cet âge. A titre d'exemple, l'âge de défaillance pertinent peut correspondre à l'âge minimal $$T_0 = \min_{i=1,...,n} t_i.$$ On notera que cet âge de défaillance pertinent $T_0$ permet d'indiquer la date de passage en atelier.

A l'étape E40, les moyens de traitement 11 sont configurés pour associer au modèle de défaillance pertinent Mi les règles R de décision de niveau d'intervention sur le moteur 1 en fonction de l'ensemble de paramètres P1, P2,..., Pi relatifs à ce moteur 1.

Avantageusement, l'ensemble de paramètres influents comporte les contraintes de reconstruction du moteur ainsi que des paramètres concernant l'âge du moteur comprenant l'âge du moteur au moment de la défaillance, l'antériorité technique (ou durée de fonctionnement) du moteur exprimée en heures ou cycles de fonctionnement depuis son dernier passage en atelier, le rang ou indice SV (Shop Visit) correspondant au nombre de passages du moteur en atelier 3, et le potentiel de durée de vie restant pour chacune d'une pluralité de pièces à durée limitée LLP (Life Limited Part) du moteur 1.

A l'étape E50, les moyens de traitement 11 sont configurés pour déterminer en fonction de ces règles R de décision le niveau d'intervention Wf (Workscope) requis de maintenance à accomplir sur le moteur 1.

Ainsi, les moyens de traitement 11 font le lien entre la cause la plus probable de défaillance (c'est-à-dire, le modèle de défaillance pertinent) et des paramètres influents pouvant comprendre l'antériorité du moteur, les contraintes de reconstruction et son rang de passage en atelier, afin de programmer le niveau d'intervention le plus réaliste possible au moment du passage en atelier indiqué par l'âge de défaillance pertinent $T_0$ déterminé à l'étape E30.

La Fig. 3 illustre un mode de réalisation particulier du procédé de prévision d'opérations de maintenance de la Fig. 2.

L'étape E11 concerne l'initialisation de données, paramètres P1,...Pi, et variables d'entrées comme à l'étape E10 de la figure précédente. Plus particulièrement, selon cet exemple, l'ensemble de règles R de décision de niveau d'intervention sur le moteur 1 comporte un ensemble de premiers modules de règles R1 et un autre ensemble de seconds modules de règles R2.

L'ensemble de premiers modules de règles R1 est défini de manière en ce que chacun de ces premiers modules soit associé à un modèle de défaillance déterminé et à un rang SV déterminé de passage en atelier 3.

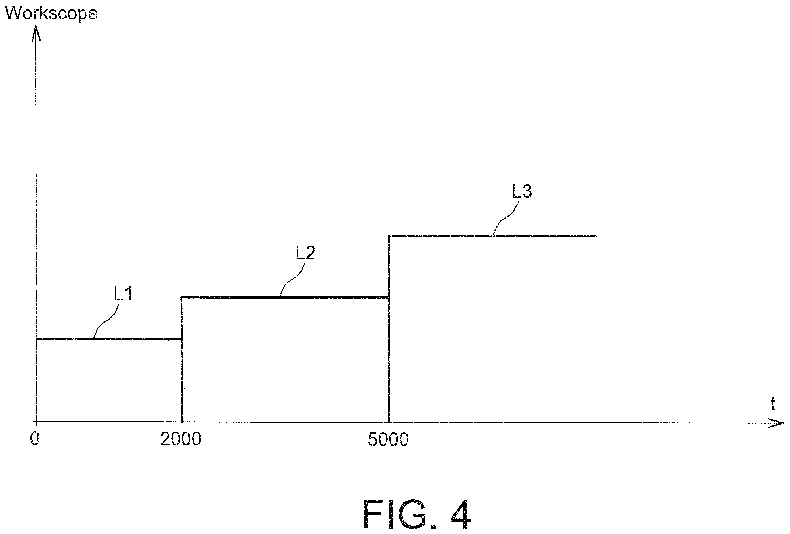

La Fig. 4 illustre un exemple d'un premier module de règles définissant une pluralité de paliers L1, L2, L3 ou niveaux d'intervention par rapport à des durées de fonctionnement du moteur. Autrement dit, un premier module de règles R1 contient, pour les différentes interventions les « temps sous aile critiques » de choix du niveau d'intervention. Les différentes interventions peuvent concerner le compresseur basse pression BP, le compresseur haute pression HP, la chambre de combustion, la turbine haute pression THP, la turbine basse pression TBP etc.. Par exemple, la régénération de la marge en température de sortie des gaz d'échappement EGT (Exhaust Gas Temperature) peut être réalisée en intervenant sur le générateur de gaz « Core » du moteur (c'est-à-dire sur l'ensemble compresseur haute pression HP, chambre de combustion et turbine haute pression THP).

L'exemple de la Fig. 4 illustre trois paliers indiquant la nature de l'intervention (workscope) due par une cause de défaillance X donnée en fonction du temps t sous aile du moteur 1. Ce graphique montre un premier palier L1 appelé SV (shop visit) légère entre 0 et 2000 cycles, un deuxième palier L2 appelé SV moyenne entre 2000 et 5000 cycles, et un troisième palier L3 appelé SV lourde pour un temps sous aile supérieur à 5000 cycles. Un palier SV légère correspond à un passage en atelier pour un niveau d'intervention (workscope) réduit, un palier SV moyenne correspond à une intervention au niveau du générateur de gaz « Core » du moteur, et un palier SV lourde correspond à une intervention aux niveaux du « Core » et de la turbine basse pression TBP du moteur.

A titre d'exemple les premiers modules de règles R1 peuvent correspondre à des données tabulaires sous forme de valeurs séparées par des virgules à l'aide de fichiers au format csv (comma-separated values) appelés « cartes ». Ainsi, la carte pour le rang 1 de passage en atelier de la Fig. 4 peut être structurée de la manière suivante :

- Date carte ; Paliers ; cause X ; palier 1 ; rang 1 ; modèle moteur ; rating moteur (c'est-à-dire, un sous modèle du moteur en fonction de la poussée délivrée par le moteur); 0 ; 2000 ; petite sv.

- Date carte ; Paliers ; cause X ; palier 2 ; rang 1 ; modèle moteur ; rating moteur ; 2000 ; 5000 ; moyenne sv.
- Date carte ; Paliers ; cause X ; palier 3 ; rang 1 ; modèle moteur ; rating moteur ; 5000 ; 50000 ; lourde sv.

Les bornes inférieure et supérieure de chaque palier L1, L2, L3 sont définies pour chaque type de moteur par rapport à son environnement. Avantageusement, ces bornes sont modifiées ou ajustées en fonction du retour d'expérience sur les interventions faites en atelier 3.

Par ailleurs, l'ensemble de seconds modules de règles R2 définissent pour chacun des paliers L1, L2, L3 des premiers modules R1, le niveau final d'intervention en fonction des contraintes de reconstruction du moteur 1. Autrement dit, pour chaque premier module de règles R1, il existe un second module de règles R2 définissant des relations entre les niveaux d'intervention du premier module de règles et des opérations finales de maintenance. Les seconds modules de règles R2 peuvent aussi être créés à l'aide de fichiers ou cartes au format csv.

Les étapes E20 et E30 de 1a Fig. 3 sont similaires à celles décrites par rapport à la Fig. 2.

Ainsi, à l'étape E20, les moyens de traitement 11 disposent de l'ensemble de modèles de défaillances M1, M2, M3,..., Mn adaptés au moteur 1.

A titre d' exemple, on dispose d'un premier modèle de défaillance M1 concernant une cause de défaillance liée à la température de sortie des gaz d'échappement EGT (Exhaust Gas Temperature), un deuxième modèle de défaillance M2 concernant une cause de défaillance sur le Core, un troisième modèle de défaillance M3 concernant une cause de défaillance sur la TBP, et un $n^{\text{ième}}$ modèle de défaillance Mn concernant une cause de défaillance sur la soufflante Fan.

Ensuite, à l'étape E30, les moyens de traitement 11 confrontent l'ensemble de modèles de défaillances M1, M2, M3,..., Mn adaptés au moteur 1 pour sélectionner un modèle de défaillance pertinent Mi avec l'âge $T_0$ qu'aura le moteur 1 au moment de la défaillance.

En se référant à l'exemple précédent, supposons que le modèle pertinent Mi est le premier modèle de défaillance M1 relatif à l'EGT à 18 kcycles qui a été sélectionné suite à la confrontation des modèles de défaillances M1, M2, M3,..., Mn et d'un potentiel LLP initial de 20 kcycles sur le deuxième modèle de défaillance M2 relatif au Core, 25 kcycles sur le troisième modèle de défaillance M3 relatif au TBP, et 30 kcycles sur le $n^{\text{ième}}$ modèle de défaillance Mn relatif au Fan.

Aux étapes E41 et E42, les moyens de traitement 11 sont configurés pour associer au modèle de défaillance pertinent Mi des règles de décision comportant les premier et second modules de règles en fonction de l'ensemble de paramètres P1,...,Pi relatifs au moteur.

Plus particulièrement, à l'étape E41, les moyens de traitement 11 associent au modèle de défaillance pertinent Mi un premier module de règles R1 définissant une pluralité de niveaux d'intervention L1, L2, L3 par rapport à des durées de fonctionnement du moteur 1.

Ensuite, les moyens de traitement 11 sélectionnent un niveau pertinent parmi la pluralité de niveaux d' intervention L1, L2, L3 en fonction de l'âge de défaillance $T_0$ associée au modèle de défaillance pertinent Mi sélectionné à l'étape E30. Ce premier module de règles R1 permet de fournir un niveau d'intervention minimal d'opérations de maintenance.

Dans le cas de l'exemple précédent, le modèle de défaillance pertinent M1 concernant la défaillance EGT à 18 kcycles se place dans le deuxième palier L2 du premier module de règles R1 associé à un SV moyenne pour une intervention minimale sur le « Core ».

A l'étape E42, les moyens de traitement 11 sélectionnent le second module de règles R2 définissant les relations entre les niveaux d'intervention L1, L2, L3 du premier module de règles R1 associé au modèle de défaillance pertinent Mi, et les opérations de maintenance correspondants.

Le second module de règles R2 permet aux moyens de traitement 11 de déterminer le niveau d'intervention requis de maintenance en fonction du niveau pertinent L2 sélectionné à l'étape E41, des contraintes de reconstruction du moteur, et des potentiels de durée de vie restant pour chaque pièce à durée limitée LLP du moteur 1.

Par exemple, la carte du second module de règles R2 pour la cause X et le rang 1 de passage en atelier peut être structurée de la manière suivante :
Numéro Cause X ; Cause X ; palier 1 ; Besoin LLP (oui/non) ; Besoin LLP Fan (oui/non) ; Besoin LLP Core (oui/non) ; Besoin LLP TBP (oui/non) ; code workscope final ; workscope combinatoire (oui/non) ; workscope final.

Supposons que dans l'exemple exposé ci-dessus, les contraintes de reconstruction du moteur 1 sont de 8 kcycles sur les LLP lors du passage à l'atelier. Autrement dit, que le moteur 1 doit être reconstruit pour pouvoir repartir à l'issue de son passage à l'atelier pour au moins 8000 cycles. Supposons que les potentiels restants sont de 2000 cycles sur le Core, 7000 cycles sur la TBP et 12000 cycles sur le Fan. Il est donc nécessaire de changer les LLP du Core et de la TBP pour y mettre des LLP avec un potentiel supérieur à 8000 cycles. Il y a donc un besoin de LLP Core et TBP, ce qui augmente le niveau d'intervention initial Core à Core+TBP.

Ainsi, les moyens de traitement 11 déterminent en fonction de ces premier et second modules de décision le niveau d'intervention requis de maintenance Wf (workscope final) à accomplir sur le moteur 1 au moment de son passage en atelier 3 indiqué par l'âge de défaillance pertinent $T_0$ déterminé précédemment.

Avantageusement, après l'accomplissement de l'opération de maintenance sur le moteur courant, on réadapte l'ensemble de paramètres. Ceci permet de prendre en compte les résultats de l'intervention présente pour déterminer l'intervention suivante de façon encore plus fine.

On notera que pour une prévision d'opération de maintenance optimale, il est avantageux de tenir compte de tous les paramètres suivants : âge de défaillance, rang de passage en atelier, potentiel de durée de vie restant pour chacune des pièces à durée limitée LLP du moteur, et contraintes de reconstruction du moteur. Bien entendu, le procédé selon la présente invention fonctionne aussi avec plus de paramètres ou avec seulement une partie de ces paramètres. Par exemple, on peut ne pas tenir compte du paramètre correspondant au rang de passage en atelier.

**Revendications**

1. Procédé de prévision d'opérations de maintenance sur un moteur d'aéronef courant, **caractérisé en ce qu'**il comporte les étapes suivantes :

   - initialisation de données d'entrées comprenant un modèle dudit moteur et un ensemble de paramètres (P1,...,Pi) et des règles (R) de décision d'intervention sur ledit moteur ;
   - confronter un ensemble de modèles de défaillances (M1,...,Mn) adaptés audit moteur (1) courant pour sélectionner un modèle de défaillance pertinent (Mi) avec un âge de défaillance ($T_0$) définissant l'âge dudit moteur au moment de la défaillance ;
   - associer audit modèle de défaillance pertinent (Mi) les règles de décision (R) de niveau d'intervention sur ledit moteur (1) courant en fonction dudit ensemble de paramètres (P1,...Pi) relatifs audit moteur courant ; et
   - déterminer en fonction desdites règles de décision le niveau d'intervention (Wf) requis de maintenance à accomplir sur ledit moteur courant.

2. Procédé selon la revendication 1, **caractérisé en ce que** ledit ensemble de paramètres comporte les paramètres suivants : âge de défaillance, durée de fonctionnement dudit moteur courant depuis un dernier passage en atelier, rang de passage en atelier, potentiel de durée de vie restant pour chacune d'une pluralité de pièces à durée limitée LLP dudit moteur courant, et contraintes de reconstruction dudit moteur.

3. Procédé selon la revendication 1 ou 2, **caractérisé en ce que** lesdites règles de décision comportent un premier module de règles (R1) définissant une pluralité de niveaux d'intervention (L1, L2, L3) par rapport à des durées de fonctionnement dudit moteur, et **en ce qu'**un niveau pertinent est sélectionné parmi ladite pluralité de niveaux d'intervention en fonction dudit âge de défaillance ($T_0$) associée audit modèle de défaillance pertinent (Mi).

4. Procédé selon la revendication 3, **caractérisé en ce que** ledit premier module de règles (R1) est sélectionné parmi un ensemble de premiers modules de règles définis auparavant lors d'une phase d'initialisation, chacun desdits premiers modules de règles étant associé à un modèle de défaillance déterminé et à un rang déterminé de passage en atelier.

5. Procédé selon la revendication 3 ou 4, **caractérisé en ce que** lesdites règles de décision comportent un second module de règles (R2) définissant des relations entre les niveaux d'intervention dudit premier module de règles et des opérations de maintenance, et **en ce que** ledit niveau d'intervention requis de maintenance est déterminé en fonction dudit niveau pertinent, des contraintes de reconstruction dudit moteur, et des potentiels de durée de vie restant pour chacune d'une pluralité de pièces à durée limitée LLP dudit moteur courant.

6. Procédé selon l'une quelconque des revendications 1 à 5, **caractérisé en ce que** ledit ensemble de paramètres est réadapté après l'accomplissement de l'opération de maintenance sur ledit moteur courant.

7. Procédé selon l'une quelconque des revendications précédentes, **caractérisé en ce que** lesdits modèles de défaillances sont issus d'analyse du retour d'expérience sur une flotte de moteurs comportant les données suivantes : nombre de moteurs, environnement d'opération de chaque moteur, modèle de chaque moteur, condition opérationnelle de chaque moteur, lieu d'entretien de chaque moteur, durée entre l'entrée et la sortie de chaque moteur de l'atelier.

8. Système de prévision d'opérations de maintenance sur un moteur d'aéronef courant, **caractérisé en ce qu'**il comporte :

   - des moyens pour initialiser des données d'entrées comprenant un modèle dudit moteur et un ensemble de paramètres (P1,...,Pi) et des règles (R) de décision d'intervention sur ledit moteur ;- des moyens de traitement (11) pour confronter un ensemble de modèles de défaillances (M1,...,Mn) adaptés audit moteur courant pour sélectionner un modèle de défaillance pertinent (Mi) avec un âge de défaillance ($T_0$) définissant l'âge dudit moteur au moment de la défaillance ;
   - des moyens de traitement (11) pour associer audit modèle de défaillance pertinent les règles de décision de niveau d'intervention sur ledit moteur courant en fonction dudit ensemble de paramètres relatifs audit moteur courant ; et
   - des moyens de traitement (11) pour déterminer en fonction desdites règles de décision le niveau d'intervention requis de maintenance à accomplir sur ledit moteur courant.

**9.** Moyen de stockage comportant une base de données de retour d'expérience sur une flotte de moteurs depuis différents ateliers ainsi qu'un programme d'ordinateur comprenant des instructions de code adaptées à la mise en oeuvre du procédé de prévision selon l'une quelconque des revendications 1 à 7 lorsqu'il est exécuté par des moyens de traitement.

**Patentansprüche**

**1.** Verfahren zur Prognose von Wartungsarbeiten an einem gebräuchlichen Flugzeug-Triebwerk, **dadurch gekennzeichnet,** **dass** es die folgenden Verfahrensschritte umfasst:

- Initialisierung von Eingabedaten, welche ein Modell des genannten Triebwerks und einen Satz von Parametern (P1, ..., Pi) sowie Regeln (R) für die Entscheidung zur Intervention an dem genannten Triebwerk umfassen;
- Konfrontieren einer Gruppe von Störungs-Modellen (M1, ... Mn), die auf das genannte gebräuchliche Triebwerk (1) zutreffen, um ein passendes Störungs-Modell (Mi) auszuwählen, mit einem Störungsalter ($T_0$), das das Alter dieses Triebwerks zum Zeitpunkt der Störung definiert;
- Zuordnen der Entscheidungsregeln (R) bezüglich der Interventionsstufe an dem genannten gebräuchlichen Triebwerk (1) zu dem genannten passenden Störungs-Modell (Mi) in Abhängigkeit von dem genannten Satz von Parametern (P1, ..., Pi), die sich auf das genannte gebräuchliche Triebwerk beziehen; und
- Bestimmen der erforderlichen Wartungs-Interventionsstufe (Wf), die an dem genannten gebräuchlichen Triebwerk ausgeführt werden muss, abhängig von den genannten Entscheidungsregeln.

**2.** Verfahren nach Anspruch 1, **dadurch gekennzeichnet,** **dass** der genannte Satz von Parametern die folgenden Parameter enthält: Störungsalter, Betriebsdauer des genannten gebräuchlichen Triebwerks seit dem letzten Werkstattaufenthalt, Prioritätsstufe in der Werkstatt, potentiell verbleibende Lebensdauer jedes einzelnen einer Vielzahl von Teilen mit begrenzter Lebensdauer LLP dieses gebräuchlichen Triebwerks, sowie Gegebenheiten, die eine Rundumerneuerung dieses Triebwerks notwendig machen.

**3.** Verfahren nach Anspruch 1 oder 2, **dadurch gekennzeichnet,** **dass** die genannten Entscheidungsregeln ein erstes Regel-Modul (R1) enthalten, worin eine Mehrzahl von Interventionsstufen (L1, L2, L3) in Hinblick auf Betriebszeiten des genannten Triebwerks definiert sind, und dass aus der genannten Mehrzahl von Interventionsstufen in Verbindung mit dem passenden Störungs-Modell (Mi) eine dem genannten Störungsalter ($T_0$) entsprechende angemessene Stufe gewählt wird.

**4.** Verfahren nach Anspruch 3, **dadurch gekennzeichnet,** **dass** das genannte erste Regel-Modul (R1) aus einer Gruppe von ersten Regel-Modulen ausgewählt wird, die zuvor in einer Initialisierungsphase definiert werden, wobei jedes dieser ersten Regel-Module einem bestimmten Störungs-Modell und einer bestimmten Prioritätsstufe in der Werkstatt zugeordnet wird.

**5.** Verfahren nach Anspruch 3 oder 4, **dadurch gekennzeichnet,** **dass** die genannten Entscheidungsregeln ein zweites Regel-Modul (R2) enthalten, worin Beziehungen zwischen den Interventionsstufen des genannten ersten Regel-Moduls und Wartungsarbeiten bestimmt sind, und dass die genannte erforderliche Wartungs-Interventionsstufe in Abhängigkeit von dieser angemessenen Stufe, von Gegebenheiten, die eine Rundumerneuerung dieses Triebwerks notwendig machen, und von den potentiell verbleibenden Lebensdauern jedes einzelnen einer Vielzahl von Teilen mit begrenzter Lebensdauer LLP dieses gebräuchlichen Triebwerks bestimmt wird.

**6.** Verfahren nach einem der Ansprüche 1 bis 5, **dadurch gekennzeichnet,** **dass** der genannte Satz von Parametern nach der Durchführung der Wartungsarbeiten an dem genannten gebräuchlichen Triebwerk aktualisiert wird.

**7.** Verfahren nach einem der vorherigen Ansprüche, **dadurch gekennzeichnet,** **dass** die genannten Störungs-Modelle aus der Analyse der gesammelten Erfahrungen über eine Flotte von Triebwerken mit den folgenden Daten hervorgehen: Anzahl der Triebwerke, Betriebsumgebung jedes Triebwerks, Modell jedes Triebwerks, Betriebsbedingung jedes Triebwerks, Ort der Wartung jedes Triebwerks, Zeitdauer zwischen Beginn und Ende des Werkstattaufenthalts jedes Triebwerks.

**8.** System zur Prognose von Wartungsarbeiten an einem gebräuchlichen Flugzeug-Triebwerk, **dadurch gekennzeichnet,** **dass** es umfasst:

- Mittel zur Initialisierung von Eingabedaten, welche ein Modell des genannten Triebwerks und einen Satz von Parametern (P1, ..., Pi) sowie Regeln (R) für die Entscheidung zur Intervention an dem genannten Triebwerk umfassen;

- Bearbeitungsmittel (11), um eine Gruppe von Störungs-Modellen (M1, ... Mn), die auf das genannte gebräuchliche Triebwerk zutreffen, um ein passendes Störungs-Modell (Mi) auszuwählen, mit einem Störungsalter ($T_0$), das das Alter dieses Triebwerks zum Zeitpunkt der Störung definiert, zu konfrontieren;

- Bearbeitungsmittel (11), um dem genannten passenden Störungs-Modell (Mi) die Entscheidungsregeln (R) bezüglich der Interventionsstufe an dem genannten gebräuchlichen Triebwerk (1) in Abhängigkeit von dem genannten Satz von Parametern (P1, ..., Pi), die sich auf das genannte gebräuchliche Triebwerk beziehen, zuzuordnen; und

- Bearbeitungsmittel (11), um in Abhängigkeit von den genannten Entscheidungsregeln die erforderliche Wartungs-Interventionsstufe, die an dem genannten gebräuchlichen Triebwerk ausgeführt werden muss, zu bestimmen.

9. Speichermittel, die eine Datenbank der gesammelten Erfahrungswerte über eine Flotte von Triebwerken aus verschiedenen Werkstätten sowie ein Rechnerprogramm mit Code-Anweisungen enthalten, die geeignet sind, das Prognose-Verfahren nach einem der Ansprüche 1 bis 7 ins Werk zu setzen, wenn es durch Bearbeitungsmittel ausgeführt wird.


**Claims**

1. Method for predicting maintenance operations on a current aircraft engine, **characterised in that** it comprises the following steps:

   - initialisation of input data comprising a model of said engine and a set of parameters (P1,...,Pi) and workscope decision rules (R) on said engine;
   - compare a set of failure models (M1,...,Mn) adapted to said current engine (1) to select a relevant failure model (Mi) with a failure age ($T_0$) defining the age of said engine at the time of the failure;
   - associate the decision rules (R) about the workscope on said current engine (1) with said relevant failure model (Mi) as a function of said set of parameters (P1,...Pi) related to said current engine; and
   - determine the required maintenance workscope (Wf) to be done on said current engine as a function of said decision rules.

2. Method according to claim 1, **characterised in that** said set of parameters comprises the following parameters: failure age, operating duration of said current engine since the last shop visit, rank of the shop visit, potential remaining life for each of a plurality of life limited parts (LLP) of said current engine and reconstruction constraints of said engine.

3. Method according to claim 1 or 2, **characterised in that** said decision rules comprise a first rules module (R1) defining a plurality of workscopes (L1, L2, L3) relative to operating times of said engine, and **in that** a relevant workscope is selected among said plurality of workscopes as a function of said failure age ($T_0$) associated with said relevant failure model (Mi).

4. Method according to claim 3, **characterised in that** said first rules module (R1) is selected among a set of first rules modules defined previously during an initialisation phase, each of said first rules modules being associated with a determined failure model and a determined rank of the shop visit.

5. Method according to claim 3 or 4, **characterised in that** said decision rules comprise a second rules module (R2) defining relations between the workscopes of said first rules module and maintenance operations, and **in that** said required maintenance workscope is determined as a function of said relevant workscope, reconstruction constraints of said engine, and the potential remaining life for each of a plurality of life limited parts (LLP) of said current engine.

6. Method according to any one of claims 1 to 5, **characterised in that** said set of parameters is modified after the maintenance operation on said current engine has been done.

7. Method according to any one of the previous claims, **characterised in that** said failure models are derived from the analysis of operating experience on a fleet of engines comprising data including the number of engines, operating environment of each engine, model of each engine, operational condition of each engine, maintenance location of each engine, duration between entry of each engine in the workshop and its exit from the workshop.

8. System for predicting maintenance operations on a current aircraft engine, **characterised in that** it comprises:

   - means for initialising input data comprising a model of said engine and a set of parameters (P1,...,Pi) and workscope decision rules ® on said engine;
   - processing means (11) to compare a set of failure models (Ml,...,Mn) adapted to said current engine to select a relevant failure model (Mi) with a failure age ($T_0$) defining the age of said engine at the time of the failure;

- processing means (11) to associate the decision rules about the workscope on said current engine with said relevant failure model, as a function of said set of parameters related to said current engine; and

- processing means (11) to determine the required maintenance workscope to be applied to said current engine, as a function of said decision rules.

9. Storage means comprising a database of feedback experience on a fleet of engines from different workshops and a computer program comprising code instructions for implementation of the prediction method according to any one of claims 1 to 7 when it is run by processing means.

FIG. 1

FIG. 2

# FIG. 3

E11 — $P_1 \cdots P_i$, R1 , R2 ...

E20

M1 — 100% [graph: 0 2000 4000 6000 8000 10000]

M2 — 100% [graph: 0 2000 4000 6000 8000 10000]

M3 — 100% [graph: 0 2000 4000 6000 8000 10000]

Mn — 100% [graph: 0 2000 4000 6000 8000 10000]

E30 — 100% [graph with $T_0$: 0 2000 4000 6000 8000 10000] Mi

E41 — w, R1, $T_0$, t [graph: 0 2000 5000]

E51 — LLP, R2, $w_f$

FIG. 4

EP 2 678 747 B1

**EP 2 678 747 B1**